# EUROPEAN PATENT APPLICATION

(11) **EP 4 079 871 A2**
(43) Date of publication of application: **26.10.2022**
(21) Application number: 20901360.6
(22) Date of filing: 14.12.2020
(51) Int. Cl.: C21D 8/12, C22C 38/02, C22C 38/04, C22C 38/06, C22C 38/00, C22C 38/60, C23C 16/30

(54) **GRAIN-ORIENTED ELECTRICAL STEEL SHEET AND METHOD FOR MANUFACTURING SAME**

(30) Priority: 20.12.2019 KR 20190172303
(71) Applicant: POSCO, Pohang-si, Gyeongsangbuk-do 37859 (KR)
(72) Inventor: KWON, Min Serk, Pohang-si, Gyeongsangbuk-do 37859 (KR); LEE, Sangwon, Pohang-si, Gyeongsangbuk-do 37859 (KR); BAE, Jin-Su, Pohang-si, Gyeongsangbuk-do 37859 (KR)
(74) Representative: Zech, Stefan Markus
(86) International application number: PCT/KR2020/018282
(87) International publication number: WO 2021/125728

(57) **Abstract**

The present disclosure provides a manufacturing method and a grain-oriented electrical steel sheet manufactured thereby, the manufacturing method comprising the steps of: heating a slab; hot rolling the heated slab so as to manufacture a hot-rolled sheet; cold rolling the hot-rolled sheet so as to manufacture a cold-rolled sheet; decarburizing and annealing the cold-rolled steel sheet; forming a ceramic coating layer on a portion or the whole of one surface or two sides of the decarburized and annealed cold-rolled sheet by using a chemical vapor deposition (CVD) process; and finally annealing the cold-rolled sheet on which the ceramic coating layer is formed.

## Description

### [Technical Field]

Provided are a grain-oriented electrical steel sheet and a method for manufacturing the same. Specifically, provided are a grain-oriented electrical steel sheet on which a forsterite layer is not formed and a ceramic coating layer is formed after a decarburizing and annealing step, and a method for manufacturing the same.

### [Background Art]

In general, a grain-oriented electrical steel sheet contains approximately 3.1% of Si components in a steel sheet, and refers to an electrical steel sheet having extremely excellent magnetic characteristics in a rolling direction because the orientation of crystals has a texture arranged in a {100}<001>[0002] direction. The {100}<001> texture can be obtained by a combination of various processes, and in particular, a series of processes of subjecting components including the components of a steel slab to heating, hot rolling, hot band annealing, primary recrystallization annealing, and final annealing need to be very strictly controlled. Specifically, since the grain-oriented electrical steel sheet suppresses the growth of primary recrystal grains and exhibits excellent magnetic characteristics by means of a secondary recrystal structure obtained by selectively growing crystal grains in a {100}<001> orientation among crystal grains whose growth is suppressed, it is more important to provide an agent for suppressing the growth of primary recrystal grains. Moreover, in the final annealing process, it is one of the important factors in a technology of manufacturing a grain-oriented electrical steel sheet to enable crystal grains stably having a texture in a {100}<001> orientation among crystal grains whose growth is suppressed to be preferentially grown. As a primary crystal grain growth suppressing agent which may satisfy the above-described conditions and is currently and industrially widely used, examples thereof include MnS, AIN, MnSe, and the like. Specifically, MnS, AIN, MnSe, and the like contained in a steel slab are subjected to solid solution treatment by being reheated at high temperature for a long period of time, and then hot-rolled, and the components having an appropriate size and distribution in a subsequent cooling process are produced as a precipitate, and thus, may be used as the growth suppressing agent. However, there is a problem in that the steel slab needs to be heated at a high temperature. In this regard, recently, there have been efforts to improve magnetic characteristics of a grain-oriented electrical steel sheet by a method of heating a steel slab at low temperature. For this purpose, a method for adding an antimony (Sb) element to the grain-oriented electrical steel sheet has been proposed, but there has been a problem in that the transformer noise quality deteriorates because the crystal grain sizes are irregular and coarse after the final high temperature annealing.

Meanwhile, in order to minimize the power loss of the oriented electrical steel sheet, an insulation film is generally formed on the surface of the oriented electrical steel sheet, and in this case, the insulation film basically needs to have high electrical insulating properties, excellent adhesion with materials, and a uniform color having no defects in appearance. Along with the requirements, due to the recent strengthening of the international regulations for the noises of the transformer and the fierce competition among the related companies, there is a need for studies on the magnetic deformation (magnetostriction) phenomenon in order to reduce the noise from an insulation film of a grain-oriented electrical steel sheet. Specifically, when an electric field is applied to an electrical steel sheet used as a transformer core, a flicker phenomenon is caused by repeating the shrinkage and expansion, and vibration and noise are caused in a transformer due to the flicker. In the case of a generally known oriented electrical steel sheet, effects of alleviating the iron loss and reducing the noise resulting from the magnetic deformation have been attempted by forming an insulation film on a steel sheet and a forsterite-based base coating, and imparting the tensile stress to the steel sheet by using the difference in thermal expansion coefficients of the insulating films, but there is a limitation in satisfying the noise level recently required for a high-quality grain-oriented electrical steel sheet. Meanwhile, as a method for reducing the 90° magnetic domain of a grain-oriented electrical steel sheet, a wet coating method is known. Here, the 90° magnetic domain refers to a region having a magnetization oriented at a right angle with respect to the [0010] magnetic field application direction, and as the amount of the 90° magnetic domain is decreased, the magnetic deformation is reduced. However, the general wet coating method has a problem in that the transformer space factor and the efficiency deteriorate due to the disadvantages in that the effect of alleviating the noise by applying the tensile stress is insufficient, and the coating needs to be thick.

Thus, research on imparting high-tensile properties to the surface of a grain-oriented electrical steel sheet has been continuously conducted.

### [Disclosure]

### [Technical Problem]

An aspect of the present disclosure provides a grain-oriented electrical steel sheet and a method for manufacturing the same.

Specifically, an aspect of the present disclosure provides a grain-oriented electrical steel sheet in which a ceramic coating layer is formed on a forsterite layer-free base steel sheet, and a method for manufacturing the same.

### [Technical Solution]

The grain-oriented electrical steel sheet of an exemplary embodiment of the present disclosure includes: a base steel sheet; and a ceramic coating layer located in contact with the surface of the base steel sheet, and may have a weatherability of less than 35% under the conditions of 65°C, 95% humidity and 72 hours.

The ceramic coating layer may be at least one selected among TiO₂, Al₂O₃, ZrO₂, MgO, SiO₂ and Ti₃O₄.

The base steel sheet may include Si: 2.0 to 7.0 wt%, Sn: 0.01 to 0.10 wt%, Sb: 0.01 to 0.05 wt%, acid soluble Al: 0.020 to 0.040 wt%, Mn: 0.01 to 0.20 wt%, C: 0.04 to 0.07 wt%, N: 10 to 50 ppm, S: 0.001 to 0.005 wt%, the balance Fe and other inevitable impurities based on total 100 wt% of the base steel sheet.

The ceramic layer may have a thickness of 0.1 o 10 µm.

The ceramic layer may have a surface roughness of 1 µm or less.

The grain-oriented electrical steel sheet may further include an insulation coating layer on the ceramic coating layer.

The method for manufacturing a grain-oriented electrical steel sheet of an exemplary embodiment of the present disclosure may include: heating a slab including Si: 2.0 to 7.0 wt%, Sn: 0.01 to 0.10 wt%, Sb: 0.01 to 0.05 wt%, acid soluble Al: 0.020 to 0.040 wt%, Mn: 0.01 to 0.20 wt%, C: 0.04 to 0.07 wt%, N: 10 to 50 ppm, S: 0.001 to 0.005 wt%, the balance Fe and other inevitable impurities based on total 100 wt% of the base steel sheet; hot rolling the heated slab so as to manufacture a hot-rolled sheet; cold rolling the hot-rolled sheet so as to manufacture a cold-rolled sheet; decarburizing and annealing the cold-rolled steel sheet; forming a ceramic coating layer on a portion or the whole of one surface or two sides of the decarburized and annealed cold-rolled sheet by using a chemical vapor deposition (CVD) process; and final annealing the cold-rolled sheet on which the ceramic coating layer is formed.

The forming of the ceramic coating layer may be using a ceramic precursor.

The ceramic precursor may be a metal alkoxide-based compound.

The metal alkoxide-based compound may be one or more selected from the group consisting of magnesium alkoxide, zirconium alkoxide, silica alkoxide, titania alkoxide, and alumina alkoxide.

The chemical vapor deposition may be one or more selected from the group consisting of CVD, low pressure CVD (LPCVD), atmospheric pressure CVD (APCVD), plasma enhanced CVD (PECVD) and an atmospheric pressure plasma enhanced-chemical vapor deposition (APP-CVD) process.

The forming of the ceramic coating layer may include: generating plasma by forming an electric field on the surface of the steel sheet using a high-density radio frequency under atmospheric pressure conditions; and mixing a primary gas composed of one or more of Ar, He and N₂ with a gas-phase ceramic precursor to subject the resulting mixture to a contact reaction with the surface of the steel sheet.

The mixing of the primary gas composed of one or more of Ar, He and N₂ with the gas-phase ceramic precursor to subject the resulting mixture to the contact reaction with the surface of the steel sheet may include additionally mixing a secondary gas composed of one of H₂, O₂ and H₂O with the primary gas and the ceramic precursor.

The primary gas and the secondary gas may be heated at a temperature equal to or higher than the vaporization point of the ceramic precursor.

The method may further include, after the final annealing of the cold-rolled sheet on which the ceramic coating layer is formed, a step of forming an insulation film.

### [Advantageous Effects]

According to an aspect of the present invention, it is possible to provide a grain-oriented electrical steel sheet having low iron loss and excellent insulation properties, and a method for manufacturing the same.

According to an aspect of the present invention, the ceramic coating layer is a high-tensile strength coating layer and does not need to be removed unlike typical MgO annealing separators.

### [Description of the Drawings]

FIG. 1 illustrates the flow chart of a typical manufacturing process of a grain-oriented electrical steel sheet.
FIG. 2 illustrates the flow chart of the manufacturing process of the grain-oriented electrical steel sheet of an exemplary embodiment of the present invention.
FIG. 3 is a temperature change graph of the annealing heat treatment process in a secondary recrystallization annealing process, in which (A) illustrates the temperature change in the related art and (B) illustrates the temperature change of an exemplary embodiment of the present invention.
FIG. 4 is a schematic view illustrating a mechanism in which a ceramic coating layer is formed on the surface of a primary recrystallization annealed upper sheet using the atmospheric pressure plasma enhanced-CVD process of an exemplary embodiment of the present invention.
FIG. 5 illustrates a state in which TTIP, which is an example of a ceramic precursor, is dissociated in a plasma region generated by an RF power source in the atmospheric pressure plasma enhanced-CVD process of an exemplary embodiment of the present invention.

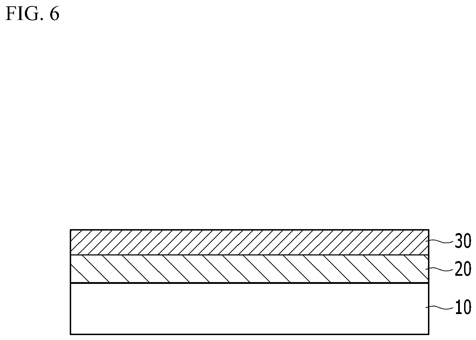

FIG. 6 illustrates a grain-oriented electrical steel sheet in which a ceramic coating layer and an insulation film coating layer are formed on the base steel sheet of an exemplary embodiment of the present invention.
FIG. 7 illustrates that a cross section of a steel sheet in which a ceramic coating layer is formed on the base steel sheet of an exemplary embodiment of the present invention is photographed by FIB-SEM.
FIG. 8 illustrates that a cross section of a steel sheet in which a ceramic coating layer is formed on the base steel sheet of a comparative example of the present invention is photographed by FIB-SEM.

### [Mode for Invention]

Terms such as first, second and third are used to describe various parts, components, regions, layers and/or sections, but are not limited thereto. These terms are used only to distinguish one part, component, region, layer or section from another part, component, region, layer or section. Thus, a first part, component, region, layer, or section to be described below could be termed a second part, component, region, layer, or section within a range not departing from the scope of the present invention.

The terminology used herein is solely for reference to specific exemplary embodiments and is not intended to limit the present invention. The singular forms used herein also include the plural forms unless the phrases do not express the opposite meaning explicitly. As used herein, the meaning of "include" specifies a specific feature, region, integer, step, action, element and/or component, and does not exclude the presence or addition of another feature, region, integer, step, action, element, and/or component.

When a part is referred to as being "above" or "on" another part, it may be directly above or on another part or may be accompanied by another part therebetween. In contrast, when one part is referred to as being "directly above" another part, no other part is interposed therebetween.

Further, unless otherwise specified, % means wt%, and 1 ppm is 0.0001 wt%.

In an exemplary embodiment of the present invention, further including an additional element means that the additional element is included while replacing iron (Fe) that is the balance by an additional amount of the additional element.

Although not differently defined, all terms including technical terms and scientific terms used herein have the same meaning as the meaning that is generally understood by a person with ordinary skill in the art to which the present invention pertains. The terms defined in generally used dictionaries are additionally interpreted to have the meaning matched with the related art document and currently disclosed contents, and are not interpreted to have an ideal meaning or a very formal meaning as long as the terms are not defined.

Hereinafter, exemplary embodiments of the present invention will be described in detail with reference to the accompanying drawings such that a person with ordinary skill in the art to which the present invention pertains can easily carry out the present invention. However, the present invention may be implemented in various different forms, and is not limited to the exemplary embodiments described herein.

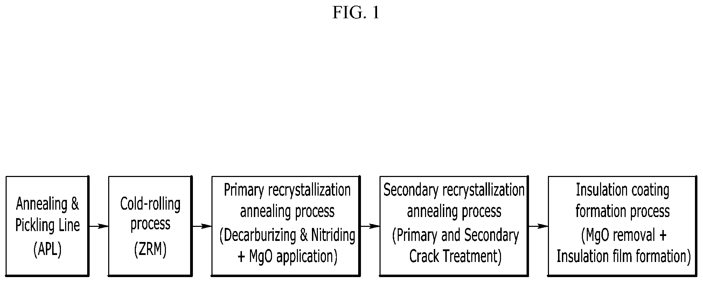

FIG. 1 illustrates the flow chart of a typical manufacturing process of a grain-oriented electrical steel sheet.

As illustrated in Figure 1, an annealing & pickling line (APL) is a step of removing the scale of a hot-rolled sheet, securing cold rollability, and precipitating and dispersing an inhibitor (AIN) of the hot-rolled sheet advantageously for the magnetism. Subsequently, the cold rolling process is a step of rolling the hot-rolled sheet to the thickness of a final product and securing a crystallographic orientation that is advantageous for the magnetism. And, a primary recrystallization annealing process is a step of removing carbon of a cold-rolled sheet by a decarburizing & nitriding line (DNL) process and forming primary recrystals by performing a nitration reaction at an appropriate temperature. Subsequently, a metal oxide layer (Mg₂SiO₄) is formed in a high-temperature annealing process (COF), which is a secondary recrystallization annealing process and secondary recrystals are formed. Finally, the material shape is corrected by an HCL process, the annealing separator is removed, and then a process of imparting tension to the surface of the electrical steel sheet by forming an insulation coating layer is performed.

In the manufacturing technique in the related art, a process of applying an annealing separator (MgO) after a decarburizing & nitriding treatment is performed in the primary recrystallization process. Accordingly, a process of performing a primary crack treatment by performing the primary heating, and subsequently the secondary heating, followed by a secondary crack treatment is performed in the secondary recrystallization annealing process.

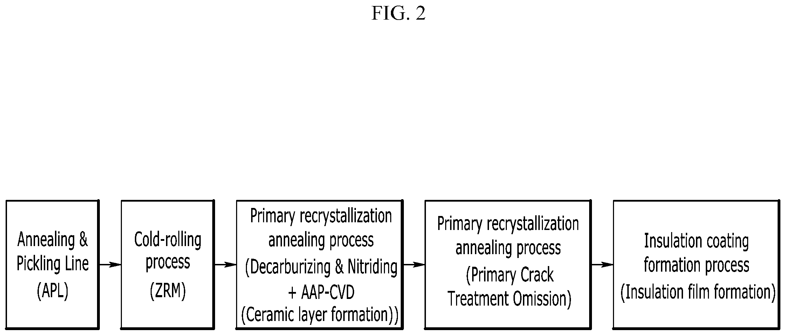

FIG. 2 illustrates the flow chart of the manufacturing process of the grain-oriented electrical steel sheet of an exemplary embodiment of the present invention.

As illustrated in FIG. 2, in an exemplary embodiment of the present invention, a ceramic coating layer is formed using an atmospheric pressure plasma enhanced-CVD (APP-CVD) process instead of applying an annealing separator (MgO) in the primary recrystallization annealing process. Then, in the secondary recrystallization annealing process, a step of primary crack treatment is performed after two-stage heating. That is, even though the present invention is the same as the manufacturing method in the related art until the steps of: heating a slab; hot rolling the heated slab; cold rolling the hot-rolled sheet; and performing a primary crystallization annealing, the present invention includes a step of forming a ceramic coating layer on a portion or the whole of one surface or two sides of a primary recrystallization annealed steel sheet by subjecting the steel sheet to a contact reaction with a gas-phase ceramic precursor in a plasma state using an atmospheric pressure plasma enhanced-CVD (APP-CVD) process instead of the step of applying an annealing separator, MgO in the related art.

Hereinafter, the method for manufacturing a grain-oriented electrical steel sheet of the present invention will be more specifically disclosed.

First, a steel sheet that has been subjected to primary recrystallization annealing is prepared in the same manner as in the manufacturing method in the related art. In this case, the cold-rolled steel sheet may be a grain-oriented electrical steel sheet, and the composition thereof is not particularly limited. However, for example, the cold-rolled steel sheet may be a cold-rolled steel sheet including Si: 2.0 to 7.0 wt%, Sn: 0.01 to 0.10 wt%, Sb: 0.01 to 0.05 wt%, acid soluble Al: 0.020 to 0.040 wt%, Mn: 0.01 to 0.20 wt%, C: 0.04 to 0.07 wt%, N: 10 to 50 ppm, S: 0.001 to 0.005 wt%, the balance Fe and other inevitable impurities based on total 100 wt%.

Hereinafter, the reasons for limiting each component will be described.

### Si: 2.0 to 7.0 wt%

Silicon (Si) serves to decrease the iron loss by increasing the resistivity of steel, and there may occur a problem in that when the content of Si is too low, the resistivity of steel is decreased, and thus the iron loss characteristics deteriorate, and secondary recrystals become unstable due to the presence of the phase transformation interval during high-temperature annealing. There may occur a problem in that when the content of Si is too high, it is difficult to perform cold rolling because brittleness is increased. Therefore, the content of Si may be adjusted within the above-described range. More specifically, Si may be included in an amount of 2.0 to 7.0 wt%.

### Sn: 0.01 to 0.10 wt%

Since Sn is an element that interferes with the movement of grain boundaries as a grain boundary segregation element, Si is an important element for reinforcing the ability to suppress the growth of crystal grains because the element allows secondary recrystals to be well developed by promoting the formation of Goss crystal grains in the {110} <001> orientation as a crystal grain growth inhibitor.

When the content of Sn is less than 0.01 wt%, the effect is reduced, and when the content exceeds 0.10 wt%, the crystal grain boundary segregation severely occurs, and as a result, the brittleness of the steel sheet is increased, thereby leading to sheet fracture during rolling. Therefore, the content of Sn is preferably 0.01 to 0.04 wt%.

### Sb: 0.01 to 0.05 wt%

Sb is an element that promotes the formation of Goss crystal grains in the {110} <001> orientation, and when the content thereof is less than 0.01 wt%, it cannot be expected to be sufficiently effective as a Goss crystal grain formation promoter, and when the content exceeds 0.05 wt%, Sb is segregated on the surface, thereby suppressing the formation of an oxide layer and causing surface defects. Therefore, the content of Sb is preferably 0.01 to 0.03 wt%.

### Acid soluble Al: 0.020 to 0.040 wt%

Al is an element which finally becomes a nitride in the form of AIN, (Al,Si)N, and (AI,Si,Mn)N, and thus, serves as an inhibitor. When the content of acid soluble Al is less than 0.020 wt%, a sufficient effect as an inhibitor cannot be expected. In contrast, when the content of acid soluble Al exceeds 0.040 wt%, an Al-based nitride is extremely coarsely precipitated and grown, and as a result, an effect as an inhibitor becomes insufficient. Therefore, the content of Al is preferably 0.020 to 0.040 wt%.

### Mn: 0.01 to 0.20 wt%

Mn has an effect of decreasing the iron loss by increasing the resistivity in the same manner as Si, and is an important element which causes secondary recrystallization by reacting with nitrogen introduced by nitriding treatment along with Si to form a precipitate of (AI,Si,Mn)N, thereby suppressing the growth of primary recrystal grains. However, when the content of Mn is too high, Mn promotes the austenite phase transformation during hot rolling, and as a result, the secondary recrystallization is destabilized by reducing the size of the primary recrystal grains. Furthermore, when the content of Mn is too low, the austenite fraction is increased during hot rolling reheating as an austeniteforming element to increase the high volume of the precipitates, and as a result, the effect of preventing the primary recrystal grains from becoming too excessive through the refinement of the precipitate and the formation of MnS during reprecipitation may be insufficient. Therefore, the content of Mn may be adjusted within the above-described range.

### C: 0.04 to 0.07 wt%

Since C is a component that does not greatly contribute to improving the magnetic characteristics of the grain-oriented electrical steel sheet in the exemplary embodiments according to the present invention, it is desirable to remove C as much as possible. However, when C is contained above a certain level, C has an effect of promoting the austenite transformation of steel during the rolling process to make the hot-rolled structure finer during hot rolling, thereby helping to form a uniform microstructure, so that it is preferred that the content of C is 0.04 wt% or more. However, when the content of C is too high, coarse carbides are generated, and as a result, it is difficult to remove the coarse carbides during decarburization, so that it is preferred that the content of C is 0.07 wt% or less.

### N: 10 to 50 ppm

N is an element that reacts with Al and the like to make crystal grains finer. When these elements are properly distributed, it may help to appropriately make the structure finer after cold rolling and secure an appropriate primary recrystal grain size as described above. However, when the content thereof is too high, the primary recrystal grains are excessively refined, and as a result, the driving force that causes crystal grain growth during the secondary recrystallization is increased by the fine crystal grains, so that the crystal grains may be grown to crystal grains in an undesired orientation. Further, when the content of N is too high, it takes a lot of time to remove N in the final annealing process, which is not preferred. Therefore, since the upper limit of the nitrogen content should be 50 ppm and the content of nitrogen solid-solubilized during slab reheating should be 10 ppm or more, it is preferred that the lower limit of the nitrogen content is 10 ppm.

### S: 0.001 to 0.005 wt%

When the content of S exceeds 0.005 wt%, S is again solid solubilized and finely precipitated during the heating of a hot-rolled slab, so that the size of primary recrystal grains is reduced and the secondary recrystallization initiation temperature is lowered to degrade the magnetism. In addition, it takes a lot of time to remove S in a solid-solubilized state in the secondary crack interval of the final annealing process, which reduces the productivity of the grain-oriented electrical steel sheet. Meanwhile, when the content of S is as low as 0.005% or less, there is an effect that the size of the initial crystal grains before cold rolling becomes coarse, so the number of grains with the {110} <001> orientation nucleated by the deformation band is increased in the primary recrystallization process. Therefore, it is desirable that the content of S is 0.005 wt% or less in order to improve the magnetism of a final product by reducing the size of the secondary recrystal grains.

In addition, since S forms MnS to affect the size of the primary recrystal grains to some extent, it is preferred to contain S in an amount of 0.001 wt% or more. Therefore, in the present invention, the content of S is preferably 0.001 to 0.005 wt%.

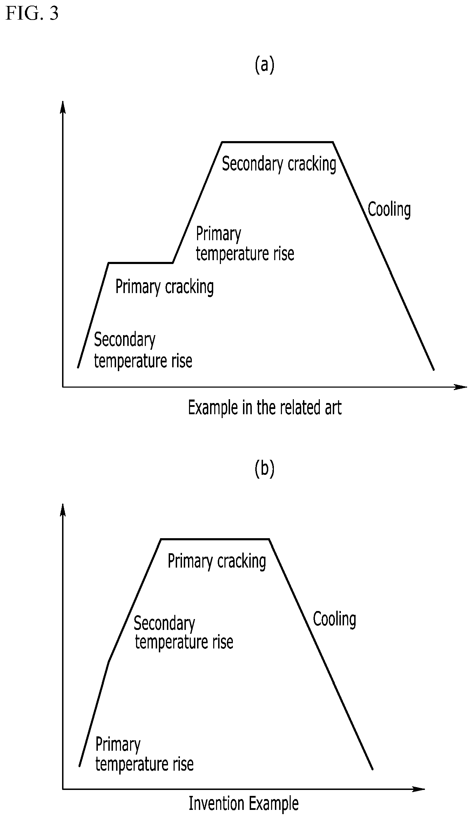

FIGS. 3(A) and 3(B) are temperature graphs of the annealing heat treatment process in the secondary recrystallization annealing process, and (A) illustrates the manufacturing method in the related art, and (B) illustrates the manufacturing method of the present invention. As illustrated in FIG. 3, it can be seen that, unlike the manufacturing method in the related art, the present invention may omit the process of performing the primary crack treatment, thereby enhancing the productivity. Furthermore, unlike the manufacturing method in the related art, the present invention does not need to remove an annealing separator.

Subsequently, a ceramic coating layer is formed on a portion or the whole of one surface or two sides of the first recrystallization annealing treated steel sheet by subjecting the steel sheet to a contact reaction with a gas-phase ceramic precursor in a plasma state using a chemical vapor deposition (CVD) process.

The chemical vapor deposition (CVD) process may be one or more selected from the group consisting of a general CVD, low pressure CVD (LPCVD), atmospheric pressure CVD (APCVD), plasma enhanced CVD (PECVD) and an atmospheric pressure plasma enhanced-chemical vapor deposition (APP-CVD) process. Specifically, the chemical vapor deposition process may be an atmospheric pressure plasma enhanced-chemical vapor deposition (APP-CVD) process.

The ceramic precursor may be a metal alkoxide-based compound.

The metal alkoxide-based compound has a chemical structural formula of M(OR)₂, M(OR)₃, or M(OR)₄, and R may be an alkyl group having 1 to 4 carbon atoms, such as methyl, ethyl, n-propyl, i-propyl, n-butyl, i-butyl or an s-butyl group. Here, M means a metal. When the carbon number exceeds 4, the carbon content becomes high, so that defects may be induced in the ceramic coating layer.

The metal alkoxide-based compound may be one or more selected from the group consisting of magnesium alkoxide, zirconium alkoxide, silica alkoxide, titania alkoxide, and alumina alkoxide. The magnesium alkoxide may have a chemical structural formula of Mg(OR)₂, the zirconium alkoxide may have a chemical structural formula of Zr(OR)₂, the silica alkoxide compound may have a chemical formula of Si(OR)₄, the titania alkoxide compound may have a chemical formula of Ti(OR)₄, and the alumina alkoxide compound may have a chemical formula of Al(OR)₃.

The silica alkoxide, titania alkoxide and alumina alkoxide have the following structural formulae as precursors of silica, titania and alumina, respectively.

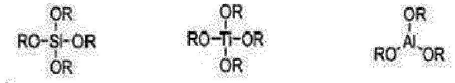

More specifically, the ceramic coating layer of an exemplary embodiment of the present invention may include at least one selected among MgO, ZrO₂, SiO₂,TiO₂, Al₂O₃, and Ti₃O₄.

A base steel sheet including the ceramic coating layer formed by an exemplary embodiment of the present disclosure may have a weather resistance of less than 35% under the conditions of 65°C, 95% humidity and 72 hours. In the present disclosure, the weather resistance means a rustgenerating region formed on the surface of a base steel sheet including a ceramic coating layer by treating the base steel sheet under the conditions of 65°C, 95% humidity, and 72 hours, and the smaller the number, the better the weather resistance. Specifically, the base steel sheet including the ceramic coating layer may have a weather resistance of 0.5 to 32%, more specifically 0.5 to 20%, and more specifically 0.5 to 10%. This is not only due to the formation of the ceramic coating layer, but also due to a difference in manufacturing methods. When a forsterite coating is removed by performing a final annealing after applying an annealing separator, which is an existing method, and a ceramic layer is formed, the weather resistance may be shown to be as high as 35% or more.

A ceramic coating layer formed by the chemical vapor deposition (CVD) process may have a thickness of 0.01 to 10 µm, specifically 0.1 to 5 µm, and more specifically 0.2 to 3 µm. When the thickness of the ceramic coating layer is less than 0.01 µm, there may be a problem in that the magnitude of the tension generated on the surface of the grain-oriented electrical steel sheet by the ceramic coating layer is too small, and thus, an iron loss reduction effect and an insulation effect are insufficient. In contrast, when the thickness of the ceramic coating layer exceeds 10 µm, the adhesion of the ceramic coating layer becomes low, so that peeling may occur.

Further, the ceramic coating layer may have a surface roughness (Ra) of 1 µm or less. Specifically, the surface roughness (Ra) may be 0.01 to 0.60 µm, more specifically, 0.05 to 0.40 µm. When the surface roughness exceeds 1 µm, there may occur a problem in that the space factor deteriorates, and thus, the transformer no-load loss is reduced. In addition, when the surface roughness is less than 0.01 µm, there may be technical difficulties from the viewpoint of large-area and high-speed production.

The steel sheet on which the ceramic coating layer is formed may be subjected to a secondary recrystallization annealing, that is, a high-temperature annealing process, in which crack treatment is performed once after two-stage heating. Compared to the manufacturing method in the related art, in which crack treatment is usually performed twice in the secondary recrystallization annealing, when a ceramic coating layer is formed, there is technical significance in that crack treatment is performed only once.

After the secondary recrystallization annealing, the step of correcting the shape of the steel sheet in the HCL process may be included.

Hereinafter, a step of forming an insulation film on the ceramic coating layer of the steel sheet may be further included. Insulation properties may be improved by further forming an insulation film layer including a metal phosphate on the ceramic coating layer.

The metal phosphate may be a phosphate including one or more selected from the group consisting of Mg, Ca, Ba, Sr, Zn, Al and Mn.

The metal phosphate may be composed of a compound produced by a chemical reaction of a metal hydroxide and phosphoric acid (H₃PO₄). The metal hydroxide may be at least one selected from the group consisting of Mg(OH)₂, Ca(OH)₂, Ba(OH)₂, Sr(OH)₂, Zn(OH)₂, Al(OH)₃, and Mn(OH)2.

Specifically, the metal element of the metal hydroxide may be formed by forming a single bond, a double bond, or a triple bond by a substitution reaction with phosphorus of phosphoric acid, and may be composed of a compound in which the amount of unreacted free phosphoric acid (H₃PO₄) is 25% or less.

The metal phosphate may be composed of a compound produced by a chemical reaction of a metal hydroxide and phosphoric acid (H₃PO₄), and the weight ratio of metal hydroxide to phosphoric acid may be represented as 1 : 100 to 40 : 100.

When too much metal hydroxide is included, the chemical reaction is not completed, and as a result, there may occur a problem in that a precipitate may be formed, and when too little metal hydroxide is included, there may occur a problem in that the corrosion resistance deteriorates, so that the range may be limited as described above.

Hereinafter, the APP-CVD process of an exemplary embodiment of the present disclosure will be described in more detail.

The process used to form the ceramic coating layer in an exemplary embodiment of the present invention is an atmospheric pressure plasma enhanced-chemical vapor deposition (APP-CVD) process. The APP-CVD process has an advantage of high deposition rate due to a higher radical density than other processes. Furthermore, unlike other processes, the APP-CVD process does not require high vacuum equipment or low vacuum equipment, and thus has an advantage of low cost. That is, since no vacuum equipment is required, the equipment is relatively easily operated, and the vapor deposition performance is excellent.

Further, the APP-CVD process of an exemplary embodiment of the present invention mixes a primary gas, which is a main gas composed of one or more of Ar, He and N₂ with a gas-phase ceramic precursor, and then supplies the resulting mixture to a reaction furnace to subject the mixture to a contact reaction with the surface of a steel sheet, in a state where plasma is generated by forming an electric field on the surface of the steel sheet using a high-density radio frequency under atmospheric conditions.

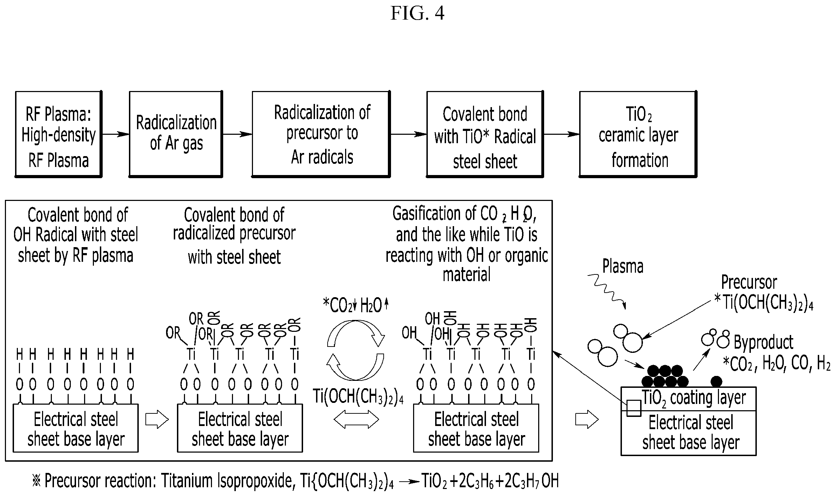

FIG. 4 illustrates a mechanism of forming a ceramic coating layer on the surface of the steel sheet using the APP-CVD process of an exemplary embodiment of the present invention.

As illustrated in FIG. 4, the APP-CVD process forms an electric field on one surface or both surfaces of the steel sheet using a high-density radio frequency (RF) (for example, 13.56 MHz) under atmospheric conditions. Then, when a primary gas such as Ar, He or N₂ is injected through a hole nozzle, a line nozzle, or a surface nozzle, electrons are separated and radicalized under an electric field to show polarity.

In an exemplary embodiment of the invention, the RF plasma source a large number of line sources or 2D square sources may be used as an RF plasma source in some cases. This may also change the type of source depending on the optimized coating speed and the progress speed of the base layer.

Subsequently, while reciprocating in a reaction furnace under an AC power of 50 to 60 Hz between the RF power source and the steel plate, Ar radicals and electrons dissociate a gas-phase ceramic precursor (for example, TTIP: titanium isopropoxide, Ti{OCH(CH₃)₂}₄) mixed with the primary gas while colliding with the precursor, thereby forming precursor radicals.

In this case, a ceramic precursor such as TTIP of an exemplary embodiment of the present invention is stored in a liquid state and heated at 50 to 100°C to be vaporized, and a primary gas composed of one or more of Ar, He and N₂ is mixed with TTIP, then passes through the RF power source, passes through a gas injection nozzle, and flows into the reaction furnace.

In this case, an exemplary embodiment of the present invention may improve the purity of the ceramic coating layer by introducing a secondary gas (auxiliary gas) which is one or more selected from the group consisting of O₂, H₂ and H₂O, if necessary, along with the primary gas auxiliary gas, in order to further improve the quality of the coating layer. That is, a compound having an undesired composition may be removed through a reaction with the secondary gas by introducing the secondary gas in order to improve the purity of the ceramic coating layer. In an exemplary embodiment of the present invention, whether or not the secondary gas is introduced may be determined by overall conditions such as whether or not the base steel sheet is heated.

As described above, in an exemplary embodiment of the present invention, a ceramic precursor in a liquid state is heated to the boiling point or higher, the primary gas and the secondary gas are heated to a temperature equal to or higher than the boiling point of the ceramic precursor using a steam heater or an electric heater in advance, and then mixed with the ceramic precursor, and the resulting mixture may be supplied in a gas state into a reaction furnace to supply the vaporized ceramic precursor gas to a plasma source.

For example, the boiling points of the precursors Al(O-sec-Bu)₃, Mg(OMe)₂ and Si(OMe)₄ used in an exemplary embodiment of the present invention are 206°C, 270°C, and 169°C, respectively. Therefore, the primary gas and the secondary gas may be supplied after heating the temperature to 150°C or higher when each precursor is used.

In this case, a ceramic coating layer may be formed using an inflow of 100 to 10,000 SLM for the primary gas, an inflow of 0 to 1,000 SCCM for the secondary gas, and an inflow of 10 to 1,000 SLM for the vaporized ceramic precursor.

In addition, in an exemplary embodiment of the present invention, a ceramic coating layer (for example, TiO₂) is formed on the surface while dissociated radicals collide with a grain-oriented electrical steel sheet which is electrically ground or shows the (-) electrode.

In an exemplary embodiment of the present invention, the principle of plasma generation is that electrons are accelerated by an electric field applied by a high-density RF power source, and neutral particles such as atoms and molecules collide with each other to generate ionization, excitation, and dissociation. Among them, an activated species formed through excitation and dissociation may react with radicals to finally form a desired ceramic coating layer.

When the mechanism of laminating the ceramic coating layer TiO₂ of an exemplary embodiment of the present invention is simplified and described, the ceramic precursor TTIP is decomposed by the following reaction formula by plasma under an electric field and may be laminated on the surface of the base layer.

### Ti (OR)4→Ti*(OH)ₓ₋₁ (OR)₄₋ₓ→(HO)ₓ (RO)₃₋ₓTi-O-Ti(OH)ₓ₋₁ (OR)₄₋₁→Ti-O-Ti network

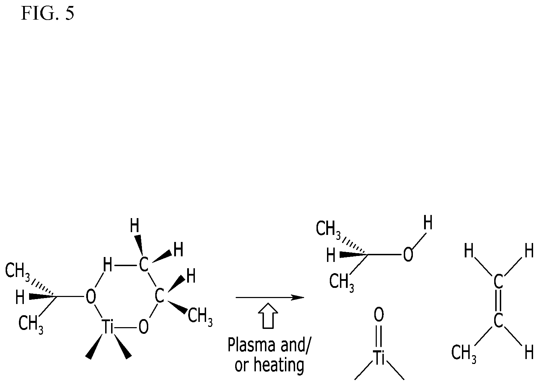

FIG. 5 illustrates a state in which TTIP, which is an example of a ceramic precursor, is dissociated in a plasma region generated by an RF power source in the APP-CVD process of an exemplary embodiment of the present invention.

Meanwhile, in an exemplary embodiment of the present invention, the RF power source needs to be about 500 kW to 10 MW in order to laminate a ceramic coating layer having a thickness of 0.05 to 0.5 µm on a 1-m width of a steel sheet traveling at a speed of 100 mpm using APP-CVD. In addition, one or more RF power sources may stably maintain an electric field by a Power Matching System.

In a grain-oriented electrical steel sheet 100 according to an exemplary embodiment of the present invention, a ceramic coating layer 20 may be formed on a base steel sheet 10. Furthermore, an insulation coating layer 30 may be formed on the ceramic coating layer 20 to impart a film tension effect and maximize the effect of improving the iron loss of the grain-oriented electrical steel sheet.

Hereinafter, the present invention will be described in more detail through the examples. However, such examples are merely for exemplifying the present invention, and the present invention is not limited thereto.

### Experimental Examples - Characteristics by type of ceramic precursor Examples 1 to 9

A slab including silicon (Si): 3.4 wt%, aluminum (Al): 0.03 wt%, manganese (Mn): 0.10 wt%, antimony (Sb): 0.05 wt% and tin (Sn): 0.05 wt%, in which the balance was composed of Fe and other inevitable impurities, was prepared.

The slab was heated at 1,150°C for 220 minutes, and then hot rolled to a thickness of 2.3 mm, thereby manufacturing a hot-rolled sheet.

The hot-rolled sheet was heated to 1,120°C, maintained at 920°C for 95 seconds, and then rapidly cooled with water and pickled, and cold rolled to a thickness of 0.23 mm, thereby manufacturing a cold-rolled sheet.

The cold-rolled sheet was introduced into a furnace maintained at 850°C, and then the dew point temperature and the oxidation capacity were adjusted, and a decarburizing and nitriding and a primary recrystallization annealing were simultaneously carried out in a mixed gas atmosphere of hydrogen, nitrogen, and ammonia, thereby manufacturing a decarburization-annealed steel sheet.

Thereafter, a ceramic coating layer was formed on the surfaces of the first recrystallization annealed steel sheets manufactured as described above@@@using an APP-CVD process without applying an annealing separator thereon.

Specifically, before the APP-CVD process, the grain-oriented electrical steel sheet was indirectly heated at a temperature of 200°C, and then the steel sheet was put into the APP-CVD reaction furnace.

Meanwhile, in this case, the APP-CVD process formed an electric field on one surface or both surfaces of the grain-oriented electrical steel sheet using a radio frequency of 13.56 MHz under atmospheric conditions, and allowed Ar gas to flow into the reaction furnace. Then, after a liquid ceramic precursor was heated and vaporized under an AC power of 50 to 60 Hz between the RF Power Source and the steel plate, Ar gas and H₂ gas were mixed and put into the reaction furnace, thereby forming ceramic coating layers having different thicknesses on the surfaces of the electrical steel sheets, respectively.

Then, the steel sheet on which the ceramic coating layer was formed was finally annealed. In this case, the crack temperature during the final annealing was set to 1,200°C, and the rate in the temperature interval of the temperature rise interval was set to 15°C/hr. Further, the final annealing was carried out in a mixed gas atmosphere of 50 vol% of nitrogen and 50 vol% of hydrogen until 1,200°C, and after 1,200°C was reached, the steel sheet was maintained in a hydrogen gas atmosphere of 100 vol% for 15 hours, and then was subjected to furnace cooling.

Then, after a solution obtained by mixing colloidal silica with a phosphate in which aluminum and magnesium were mixed at a weight ratio of 1:1 at a ratio of 4:6 was applied to the surface of the steel sheet that had been finally annealed, the steel sheet was heat-treated under a temperature condition of 920°C for 45 seconds and cooled in the air. The application amount of the phosphate insulation film is 3.5 g/m2.

### Comparative Examples 1 to 3

In Comparative Examples 1 and 2, grain-oriented electrical steel sheets were manufactured in the same manner as in the Examples, except that as a method in the related art, a slurry was prepared by mixing distilled water with an annealing separator whose main component is MgO, the slurry was applied using a roll, and the like, and the cold-rolled sheet was finally annealed.

In Comparative Example 3, a grain-oriented electrical steel sheet was manufactured in the same manner as in the Examples, except that the coating thickness was increased to 5.5 µm.

Under the conditions of 1.7 T and 50 Hz, the magnetic characteristics and noise characteristics of each manufactured grain-oriented electrical steel sheet were evaluated, and the results are shown in Table 1.

For the magnetic characteristics of the electrical steel sheet, W17/50 and B8 are typically used as a representative value. W17/50 means a power loss appearing when a magnetic field with a frequency of 50 Hz is magnetized by alternating current until 1.7 Tesla. Here, Tesla is a unit of a magnetic flux density meaning a magnetic flux per a unit area. B8 denotes the value of the density of magnetic flux flowing through an electrical steel sheet when a current amount of 800 A/m is flowed into a winding wire winding the periphery of the electrical steel sheet. Weather resistance indicates the area of rust generated on the surface of the steel sheet in which the coating material shown in Table 1 was applied or vapor-deposited onto the surface of the decarburized sheet and a final annealing was completed under the conditions of 65°C, 95% humidity, and 72 hours.

**(Table 1)**

| Classif ication | Coating material (precursor) | Coating thickness (µm) | Iron loss (W17/50) | Magnetic flux density (BB) | Weather resistance (%) |
|---|---|---|---|---|---|
| Comp arative Exam ple 1 | MgO | 1.5 | 0.950 | 1.907 | 89.1 |
| Comp arative Exam ple 2 | MgO | 4.5 | 0.870 | 1.908 | 66.6 |
| Exam ple 1 | Mg(OMe)₂ | 0.5 | 0.845 | 1.909 | 31.7 |
| Exam ple 2 | Zr(OBu)₄ | 0.7 | 0.752 | 1.928 | 23.1 |
| Exam ple 3 | Si(OMe)₄ | 0.3 | 0.735 | 1.925 | 29.7 |
| Exam ple 4 | Si(OEt)₄ | 0.5 | 0.740 | 1.930 | 26.9 |
| Exam ple 5 | Al(OⁱPr)₃ | 1.2 | 0.680 | 1.942 | 7.8 |
| Exam ple 6 | Al(O-sec-Bu)₃ | 0.5 | 0.665 | 1.938 | 2.5 |
| Exam ple 7 | Ti(OⁱPr)₄ | 0.5 | 0.620 | 1.932 | 12.8 |
| Exam ple 8 | Zr(OBu)4:Si(OMe)4=1:1 | 1.5 | 0.705 | 1.927 | 8.0 |
| Exam ple 9 | Al(OⁱPr)₃:Ti(OⁱPr)₄=1:1 | 2.7 | 0.720 | 1.930 | 0.9 |
| Comp arative Exam ple 3 | Si(OMe)₄ | 5.5 | 0.890 | 1.899 | 62.5 |

In the Examples, Me, Et, Pr, and Bu mean methyl, ethyl, propane and butyl, respectively.

As shown in Table 1, it can be confirmed that Examples 1 to 9 in which a ceramic film is formed using an APP-CVD process show better iron loss characteristics than Comparative Examples 1 and 2 to which MgO, which is an annealing separator, is applied.

When the ceramic coating layer is formed to be thick, the film tension is increased, which is advantageous for iron loss quality, but when the ceramic coating layer is formed too thick as in the case of Example 10, cracks occur in the coating, so that rather, there is a problem in that iron loss deteriorates.

Since the ceramic layer formed on the surface of the sample in which the final annealing was completed by applying an existing MgO annealing separator was non-uniform, a problem in that rust of 60% or more was generated was confirmed as a result of evaluating the weather resistance. The rust generated on the surface interferes with the movement of the magnetic domain, and thus worsens iron loss, and the surface quality such as insulation and adhesion deteriorates. In contrast, when the ceramic precursor is vapor-deposited, the weather resistance is excellent even though a smaller thickness is formed compared to the comparative examples, and in particular, when the Al precursor is vapor-deposited, the formation of a dense and uniform ceramic coating layer showed very good weather resistance results. In contrast, when the ceramic coating layer is formed to be too thick, the weather resistance is shown to be inferior, which is considered to be due to the generation of a film peeling.

### Experimental Example 2: Evaluation of insulation properties, space factor and adhesion

### Examples 10 to 20

A slab including silicon (Si): 3.3 wt%, aluminum (Al): 0.28 wt%, manganese (Mn): 0.15 wt%, antimony (Sb): 0.02 wt% and tin (Sn): 0.06 wt%, in which the balance was composed of Fe and other inevitable impurities, was prepared.

The slab was heated at 1,150°C for 220 minutes, and then hot rolled to a thickness of 2.3 mm, thereby manufacturing a hot-rolled sheet. The hot-rolled sheet was heated to 1,120°C, maintained at 920°C for 95 seconds, and then rapidly cooled with water and pickled, and cold rolled to a thickness of 0.23 mm, thereby manufacturing a cold-rolled sheet.

The cold-rolled sheet was introduced into a furnace maintained at 820°C, and then the dew point temperature and the oxidation capacity were adjusted, and a decarburizing and nitriding and a primary recrystallization annealing were simultaneously carried out in a mixed gas atmosphere of hydrogen, nitrogen, and ammonia, thereby manufacturing a decarburization-annealed steel sheet.

Thereafter, the surface of the primary recrystallization annealed steel sheet was coated with the ceramic precursor by applying the APP-CVD method. The application amount of the ceramic precursor was 4.5 g/m² in the same manner. In this case, the ceramic precursor was varied.

During the final annealing, a first cracking temperature and a second cracking temperature were set to 700°C and 1,200°C, respectively, and the rate in the temperature interval of the temperature rise interval was set to 15°C/hr. Further, the final annealing was carried out in a mixed gas atmosphere of 25 vol% of nitrogen and 75 vol% of hydrogen until 1,200°C, and after 1,200°C was reached, the steel sheet was maintained in a hydrogen gas atmosphere of 100 vol% for 15 hours, and then was subjected to furnace cooling.

Then, after a solution obtained by mixing colloidal silica with a phosphate in which aluminum and magnesium were mixed at a weight ratio of 2:1 at a ratio of 4:6 was applied to the surface of the steel sheet that had been finally annealed, the steel sheet was heat-treated under a temperature condition of 760°C for 50 seconds and cooled in the air. The application amount of the phosphate insulation film is 3.2 g/m².

### Comparative Example 4

In Comparative Example 4, a grain-oriented electrical steel sheet was manufactured in the same manner as in Examples 10 to 20, except that as a method in the related art, a slurry was prepared by mixing distilled water with an annealing separator whose main component is MgO, the slurry was applied using a roll, and the like, and the cold-rolled sheet was finally annealed.

For the insulation properties, the upper portion of the coating was measured by utilizing a Franklin measuring device in accordance with the ASTM A717 International Standard.

The space factor was measured using a measurement apparatus in accordance with the JIS C2550 International Standard. After a plurality of electrical steel sheets was laminated, a uniform pressure of 1 MPa was applied to the surface, and then the space factor was measured by dividing the actual weight ratio according to the lamination of electrical steel sheets by a theoretical weight through precise measurement of the height of the four surfaces of the sample.

Adhesion is expressed as a minimum arc diameter without film peeling when the sample is bent to 180° in contact with an arc of 10 to 100 mm.

**(Table 2)**

| Classification | Coating material (precursor) | Insulation (mA) | Adhesion (mmφ) | Space factor (%) |
|---|---|---|---|---|
| Example 10 | Mg (OCH₂CH₃)₂ | 550 | 20 | 98.7 |
| Example 11 | Zr (OCH2CH3)2 | 420 | 25 | 98.5 |
| Example 12 | Mg(OMe)₂ | 750 | 30 | 99.2 |
| Example 13 | Zr(OBu)₄ | 420 | 25 | 98.0 |
| Example 14 | Si(OMe)₄ | 13 | 30 | 97.8 |
| Example 15 | Si(OEt)₄ | 45 | 30 | 98.2 |
| Example 16 | Al(OⁱPr)₃ | 25 | 10 | 98.5 |
| Example 17 | Al(O-sec-Bu)₃ | 55 | 20 | 98.4 |
| Example 18 | Ti(OⁱPr)₄ | 115 | 10 | 99.0 |
| Example 19 | Zr(OBu)4: Al(OⁱPr)₃=1:1 | 72 | 30 | 97.9 |
| Example 20 | Al(OⁱPr)₃:Ti(OⁱPr)₄=1:1 | 20 | 25 | 98.3 |
| Comparative Example 4 | MgO | 560 | 35 | 96.3 |

As shown in Table 2, it can be confirmed that the results of Invention Examples 10 to 20 have excellent insulation, space factor, and adhesion.

### Experimental Example 3: Evaluation of magnetic characteristics, space factor and noise characteristics of 1000 kVA transformer

Examples 17 to 19 and Comparative Example 4 were selected as the grain-oriented electrical steel sheets, laser magnetic domain micronization treatment was performed, a 1000 kVA transformer was manufactured, and the results evaluated under 60 Hz conditions according to the design magnetic flux density are shown in Table 3.

**[Table 3]**

| Classificatio n | Magnetic characteristics | | Space factor (%) | Noise (dBA) |
|---|---|---|---|---|
| | W17/50 (W/kg) | B8 (T) | | |
| Example 17 | 0.56 | 1.92 | 97.7 | 41.2 |
| Example 18 | 0.52 | 1.91 | 98.5 | 43.7 |
| Example 19 | 0.65 | 1.93 | 98.2 | 45.3 |
| Comparativ e Example 4 | 0.78 | 1.91 | 96.5 | 55.4 |

It can be seen that Examples 17 to 19 in which the ceramic coating layer is formed have better iron loss characteristics, space factor and noise characteristics compared to Comparative Example 4 to which the existing annealing separator is applied.

### Experimental Example 4: Comparison when order of forming ceramic coating layer is varied

As a grain-oriented electrical steel sheet, an Al₂O₃ coating layer was formed using an APP-CVD process without applying an annealing separator to the surfaces of steel sheets that had been subjected to primary recrystallization annealing under the conditions of Example 6. Then, the steel sheet on which the ceramic coating layer was formed was finally annealed. In this case, the crack temperature during the final annealing was set to 1,200°C, and the rate in the temperature interval of the temperature rise interval was set to 10°C/hr. Further, the final annealing was carried out in a mixed gas atmosphere of 30 vol% of nitrogen and 70 vol% of hydrogen until 1,200°C, and after 1,200°C was reached, the steel sheet was maintained in a hydrogen gas atmosphere of 100 vol% for 18 hours, and then was subjected to furnace cooling (Example 21).

In Comparative Example 5, as a method in the related art, a slurry was prepared by mixing distilled water with an annealing separator whose main component is MgO, the slurry was applied using a roll, and the like, and the cold-rolled sheet was finally annealed, thereby forming a forsterite film. The steel sheet that had been completely subjected to final annealing was reacted with a hydrogen peroxide mixed solution containing 1% hydrofluoric acid for 3 minutes to remove the forsterite film. Then, an Al₂O₃ coating layer was formed using the APP-CVD process under the same conditions as in Example 21. Experimental Example 4 differs from Example 21 in that a ceramic coating layer is formed after the final annealing.

Iron loss (W17/50) means a power loss appearing when a magnetic field with a frequency of 50 Hz is magnetized by alternating current until 1.7 Tesla. Weather resistance indicates the area of rust generated on the surface of the steel sheet in which a final annealing was completed after treatment under the conditions of 65°C, 95% humidity, and 72 hours. For the insulation properties, the upper portion of the coating was measured by utilizing a Franklin measuring device in accordance with the ASTM A717 International Standard. Adhesion is expressed as a minimum arc diameter without film peeling when the sample is bent to 180° in contact with an arc of 10 to 100 mm.

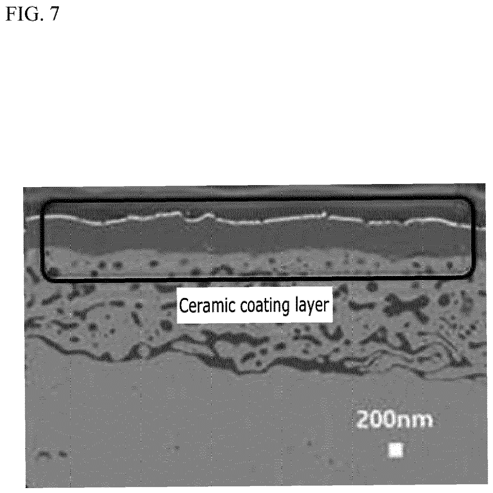

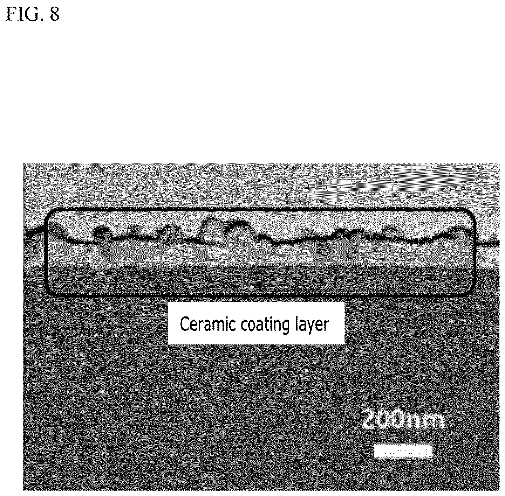

The surface shapes of Example 21 and Comparative Example 5 were observed by FIB-SEM, and are illustrated in FIGS. 7 and 8, respectively.

**[Table 4]**

| Classificatio n | Example 21 | Comparative Example 5 |
|---|---|---|
| Surface shape (FIB-SEM) | FIG. 7 | FIG. 8 |
| Constituent component | Fe-SiO2-Al2O3 | Fe-Al2O3 |
| Process step | 3-step process (primary recrystallization annealing → ceramic vapor deposition → final annealing) | 5-step process (primary recrystallization annealing → coating of MgO and other materials → final annealing → removal of forsterite film → ceramic vapor deposition) |
| Iron loss (W/kg) | 0.692 | 0.774 |
| Insulation properties (mA) | 320 | 660 |
| Weather resistance (%) | 2.5 | 37.4 |
| Adhesion (mmφ) | 15 | 35 |

In Example 20 according to the present invention, Al₂O₃ is vapor-deposited on the upper part of the SiO₂ internal oxide layer formed during the primary recrystallization annealing, and the process is simple in 3 steps and has excellent magnetism and surface quality. However, Comparative Example 5 is an electrical steel sheet formed by chemically removing the forsterite film after final annealing and then forming a ceramic coating layer using APP-CVD, and Comparative Example 5 is inferior in magnetism and surface quality to Examples, and has a complicated process in 5 steps, so that it is expected to be difficult to apply Comparative Example 5 to mass production.

Even though the Examples and Invention Examples of the present invention have been described in detail, the right scope of the present invention is not limited thereto, and it will be obvious to a person with ordinary skill in the art that various modifications and alterations are possible without departing from the technical spirit of the present invention described in the claims.

### <Description of symbols>

100: Grain-oriented electrical steel sheet
10: Base steel sheet
20: Ceramic coating layer
30: Insulation film coating layer

## Claims

1. A grain-oriented electrical steel sheet comprising:
a base steel sheet; and
a ceramic coating layer located in contact with a surface of the base steel sheet,
wherein the grain-oriented electrical steel sheet has a weather resistance of less than 35% under the conditions of 65°C, 95% humidity and 72 hours.

2. The grain-oriented electrical steel sheet of claim 1, wherein
the ceramic coating layer is at least one selected among TiO₂, Al₂O₃, ZrO₂, MgO, SiO₂ and Ti₃O₄.

3. The grain-oriented electrical steel sheet of claim 1, wherein
wherein the base steel sheet comprises Si: 2.0 to 7.0 wt%, Sn: 0.01 to 0.10 wt%, Sb: 0.01 to 0.05 wt%, acid soluble Al: 0.020 to 0.040 wt%, Mn: 0.01 to 0.20 wt%, C: 0.04 to 0.07 wt%, N: 10 to 50 ppm, S: 0.001 to 0.005 wt%, the balance Fe and other inevitable impurities based on total 100 wt% of the base steel sheet.

4. The grain-oriented electrical steel sheet of claim 1, wherein
wherein the ceramic layer has a thickness of 0.1 to 10 µm.

5. The grain-oriented electrical steel sheet of claim 1, wherein
the ceramic layer has a surface roughness of 1 µm or less.

6. The grain-oriented electrical steel sheet of claim 1,
further comprising an insulation coating layer on the ceramic coating layer.

7. A method for manufacturing a grain-oriented electrical steel sheet, the method comprising the steps of: heating a slab comprising Si: 2.0 to 7.0 wt%, Sn: 0.01 to 0.10 wt%, Sb: 0.01 to 0.05 wt%, acid soluble Al: 0.020 to 0.040 wt%, Mn: 0.01 to 0.20 wt%, C: 0.04 to 0.07 wt%, N: 10 to 50 ppm, S: 0.001 to 0.005 wt%, the balance Fe and other inevitable impurities based on total 100 wt%;
hot rolling the heated slab so as to manufacture a hot-rolled sheet;
cold rolling the hot-rolled sheet so as to manufacture a cold-rolled sheet;
decarburizing and annealing the cold-rolled steel sheet;
forming a ceramic coating layer on a portion or the whole of one surface or two sides of the decarburized and annealed cold-rolled sheet by using a chemical vapor deposition (CVD) process; and
finally annealing the cold-rolled sheet on which the ceramic coating layer is formed.

8. The method of claim 7, wherein
in the forming of the ceramic coating layer, a ceramic precursor is used.

9. The method of claim 8, wherein
the ceramic precursor is a metal alkoxide-based compound.

10. The method of claim 9, wherein
the metal alkoxide-based compound is one or more selected from the group consisting of magnesium alkoxide, zirconium alkoxide, silica alkoxide, titania alkoxide, and alumina alkoxide.

11. The method of claim 7, wherein
wherein the chemical vapor deposition is one or more selected from the group consisting of CVD, low pressure CVD (LPCVD), atmospheric pressure CVD (APCVD), plasma enhanced CVD (PECVD) and an atmospheric pressure plasma enhanced-chemical vapor deposition (APP-CVD) process.

12. The method of claim 7, wherein
the forming of the ceramic coating layer comprises the steps of:
generating plasma by forming an electric field on the surface of the steel sheet using a high-density radio frequency under atmospheric pressure conditions; and
mixing a primary gas composed of one or more of Ar, He and N₂ with a gas-phase ceramic precursor to subject the resulting mixture to a contact reaction with the surface of the steel sheet.

13. The method of claim 12, wherein
the mixing of the primary gas composed of one or more of Ar, He and N₂ with the gas-phase ceramic precursor to subject the resulting mixture to the contact reaction with the surface of the steel sheet comprises:
additionally mixing a secondary gas composed of one of H₂, O₂ and H₂O with the primary gas and the ceramic precursor.

14. The method of claim 13, wherein
the primary gas and the secondary gas are heated at a temperature equal to or higher than the vaporization point of the ceramic precursor.

15. The method of claim 7, further comprising,
after the final annealing of the cold-rolled sheet on which the ceramic coating layer is formed,
a step of forming an insulation film.
